# FASCICULE DE BREVET EUROPEEN

(11) **EP 3 552 226 B1**
(45) Date de publication et mention de la délivrance du brevet: **06.01.2021**
(21) Numéro de dépôt: 17809324.1
(22) Date de dépôt: 08.12.2017
(51) Int. Cl.: H01L 21/78, H01L 21/02, H01L 21/20

(54) **PROCÉDÉ DE TRANSFERT DE COUCHES MINCES**
VERFAHREN ZUR ÜBERTRAGUNG VON DÜNNSCHICHTEN
METHOD FOR TRANSFERRING THIN FILMS

(30) Priorité: 08.12.2016 FR 1662146
(43) Date de publication de la demande: 16.10.2019
(73) Titulaire: Commissariat à l'Énergie Atomique et aux Énergies Alternatives, 75015 Paris (FR)
(72) Inventeur: MONTMEAT, Pierre, 38190 Froges (FR); FOURNEL, Frank, 38190 Villard-Bonnot (FR)
(74) Mandataire: Decobert, Jean-Pascal
(86) Numéro de dépôt international: PCT/EP2017/081999
(87) Numéro de publication internationale: WO 2018/104513

(56) Documents cités:
- US-A1- 2013 092 320
- CHEN WAYNE ET AL: "Double-flip transfer of indium phosphide layers via adhesive wafer bonding and ion-cutting process", APPLIED PHYSICS LETTERS, A I P PUBLISHING LLC, US, vol. 90, no. 5, 2 février 2007 (2007-02-02), pages 52114-052114, XP012095828, ISSN: 0003-6951, DOI: 10.1063/1.2450665
- COLINGE C ET AL: "Silicon layer transfer using wafer bonding and debonding", JOURNAL OF ELECTRONIC MATERIALS, WARRENDALE, PA, US, vol. 30, no. 7, 1 janvier 2001 (2001-01-01), pages 841-844, XP002496475, ISSN: 0361-5235, DOI: 10.1007/S11664-001-0068-1

## Description

### DOMAINE DE L'INVENTION

La présente invention concerne en général l'industrie de la microélectronique, en particulier pour la fabrication de dispositifs microélectroniques en couche mince (de faible épaisseur, par exemple inférieure à 500nm voire inférieure à 200 nm) portés par un support souple, de sorte à obtenir un ensemble flexible.

Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

### ARRIERE-PLAN TECHNOLOGIQUE

Depuis une vingtaine d'année, l'électronique sur support souple connait un essor remarquable. Les applications sont variées : cellules photovoltaïques, diodes organiques, capteurs biologiques pour les mesures in vivo, etc.... Dans ce contexte, il apparait souvent nécessaire d'élaborer un ensemble hybride dans lequel le dispositif électronique, à base de matériaux bien souvent inorganiques, est associé à un support souple fait d'un matériau flexible comme un polymère. Il faut assurer une bonne cohésion entre le matériau inorganique qui se présente sous la forme d'un film plus ou moins épais et le support souple.

Dans le cas où le film est un semi-conducteur cristallisé, les méthodes de transfert de film sont souvent utilisées.

Il a par exemple été démontré que l'on pouvait transférer un film fin de silicium sur un support flexible. C'est ce que propose la publication intitulée « Transferred Flexible Three-Color Silicon Membrane Photodetector Arrays » IEEE Photonics Journal, Vol.7, No 1, Février 2015 avec un support flexible en Kapton® recouvert d'une couche adhésive qui reçoit une nano-membrane lors d'une phase de transfert.

Cependant, les techniques considérées actuellement pour le transfert d'un dispositif microélectronique sur un support flexible sont sujettes à des problèmes de fiabilité.

On constate des cas de fissuration de dispositifs lors du transfert, notamment du fait des contraintes engendrées sur ces fines couches généralement en matériaux fragiles notamment lorsque ces couches sont très fines, typiquement inférieures à 500nm voire à 200nm.

On connait du document brevet US 2013/0092320 A1 une méthode de transfert d'une couche mince. Cette dernière emploie une couche adhésive pour coller deux faces en regard de deux substrats à assembler.

D'autres documents décrivant un transfert de couches minces à l'aide d'une couche polymère intermédiaire sont: "Double-flip transfer of indium phosphide layers via adhesive wafer bonding and ion-cutting process", Chen Wayne et al, Applied Physics Letters, Vol. 90, Nr. 5, 2007-02-02 et "Silicon layer transfer using wafer bonding and debonding", Colinge C et al, Journal of Electronic Materials, Vol. 30, Nr 7, 2001-01-01.

C'est un objet de l'invention que de pallier au moins en partie les inconvénients des techniques actuelles, en améliorant le transfert de dispositifs microélectroniques particulièrement sur des supports flexibles.

### RESUME DE L'INVENTION

Un aspect non limitatif de l'invention est relatif à un procédé de transfert d'une couche mince sur un substrat de destination sur une face duquel une couche adhésive est présente.

De manière avantageuse, il comprend, à partir d'un support temporaire à une face duquel une première face de la couche mince est solidarisée :
- une formation d'une couche d'interface en matériau polymère sur une deuxième face de la couche mince, opposée à la première face ;
- un assemblage par collage de la couche d'interface et de la couche adhésive ;
- une séparation de la couche mince relativement au support temporaire.

Ainsi, on associe deux couches pour l'assemblage entre le support temporaire et le substrat de destination. En effet, une première couche, d'interface, s'inscrit dans la continuité de la couche mince de sorte à reprendre et répartir les contraintes mécaniques engendrées par le collage sur le substrat de destination. En outre, cette couche d'interface améliore la planéité, et plus généralement l'état de surface de l'aire de contact avec la couche adhésive en en épousant les aspérités. La rugosité est réduite pour améliorer le contact avec la deuxième couche, adhésive, que porte le substrat de destination. En absence de la couche d'interface, ce serait le collage lui-même qui épouserait la topologie de la surface de la couche mince, en incluant des contraintes. La relaxation des contraintes lors de la séparation aboutirait à la fissuration de la couche mince.

Un autre aspect séparable de la présente invention concerne un dispositif obtenu par le procédé.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- Les figures 1 à 6 illustrent des étapes successives potentielles de sorte à obtenir un support temporaire auquel est solidarisée une couche mince ;
- Les figures 7 à 11 présentent des étapes successives potentielles pour obtenir un transfert de la couche mince sur un substrat de destination ;
- Les figures 12 à 17 illustrent des étapes successives potentielles de sorte à obtenir un support temporaire auquel est solidarisée une couche mince, en alternative au cas des figures 1 à 7 ;
- Les figures 18 à 22 présentent un autre mode de réalisation des étapes successives potentielles pour obtenir un transfert de la couche mince sur un substrat de destination.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- la formation de la couche d'interface 7 comprend un étalement d'une forme liquide du matériau polymère sur la deuxième face 32 de la couche mince 3 puis une structuration du matériau polymère en phase solide;
- on utilise un support temporaire 4 comprenant une couche de séparation 5 et une poignée 41, la couche de séparation 5 étant disposée entre la couche mince 3 et la poignée 41 du support temporaire 4 lorsqu'ils sont solidarisés, et dans lequel la séparation est réalisée par une décohésion de la couche de séparation 5 relativement à la couche mince 3 ou à la poignée 41;
- la couche de séparation 5 est disposée au contact de la première face 31 de la couche mince 3 lorsque le support temporaire 4 et la couche mince 3 sont solidarisés et dans lequel on utilise un support temporaire 4 comprenant une couche d'assemblage disposée entre la couche de séparation 5 et la poignée 41, et dans lequel la décohésion a lieu à l'interface entre la couche de séparation 5 et la couche d'assemblage 6;
- la couche de séparation 5 est disposée au contact de la poignée 41 lorsque le support temporaire 4 et la couche mince 3 sont solidarisés et dans lequel on utilise un support temporaire 4 comprenant une couche d'assemblage 6 disposée entre la couche de séparation 5 et la couche mince 3, et dans lequel la décohésion a lieu à l'interface entre la couche de séparation 5 et la couche d'assemblage 6 ;
- le procédé comprend une fixation du substrat de destination 9 sur un cadre de maintien 10 par collage d'une surface du cadre de maintien 10 sur la couche adhésive 8 ;
- la fixation est opérée simultanément à l'assemblage ;
- un transfert préliminaire de la couche mince 3 est effectué depuis un substrat initial 1 vers le support temporaire 4 ;
- on utilise un substrat initial 1 comprenant une couche de base et une couche d'isolant électrique enterrée 2, la deuxième face 32 de la couche mince 3 étant disposée au contact de la couche d'isolant électrique enterrée 2 ;
- on opère une désolidarisation de la couche mince 3 relativement au substrat initial 1 par amincissement de la couche de base et de la couche d'isolant électrique enterrée 2 ou par rupture de la couche d'isolant électrique ;
- on utilise une couche adhésive 8 en matériau polymère, de préférence avec une épaisseur supérieure ou égale à 10 µm et/ou inférieure ou égale à 200 µm ;
- l'épaisseur de la couche d'interface 7 est choisie supérieure à 100 nm, et de préférence supérieure ou égale à 10 µm ;
- l'épaisseur de la couche d'interface 7 est choisie inférieure ou égale 200 µm, et de préférence inférieure ou égale à 100 µm ;
- la couche mince 3 est choisie avec une épaisseur inférieure à 500nm et possiblement inférieure ou égale à 200 nm ;
- la couche mince 3 est choisie à base d'au moins un parmi : un matériau semi-conducteur, un matériau magnétique, un matériau piézoélectrique ;
- le support de destination 9 est choisi sous forme d'une feuille de matériau polymère, ou film de polymère.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Une couche peut par ailleurs être composée de plusieurs sous-couches d'un même matériau ou de matériaux différents.

Il est précisé que dans le cadre de la présente invention, l'épaisseur d'une couche ou d'un substrat se mesure selon une direction perpendiculaire à la surface selon laquelle cette couche ou ce substrat présente son extension maximale.

L'emploi du singulier pour certains éléments de l'invention ne signifie pas obligatoirement qu'un élément donné est présent de manière unique dans l'invention. Le mot « un » ou « une » ne signifie donc pas exclusivement respectivement « un seul » ou « une seule » à moins qu'il en soit disposé autrement.

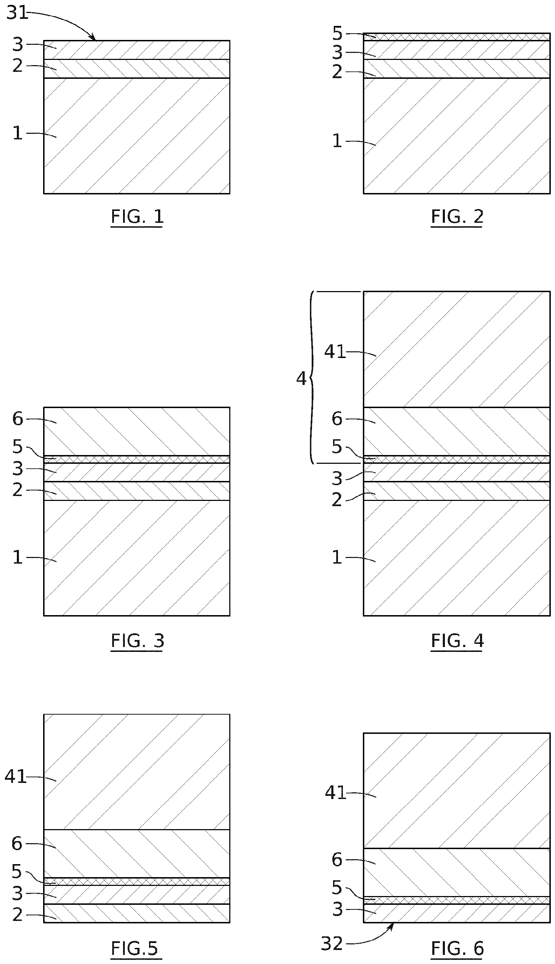

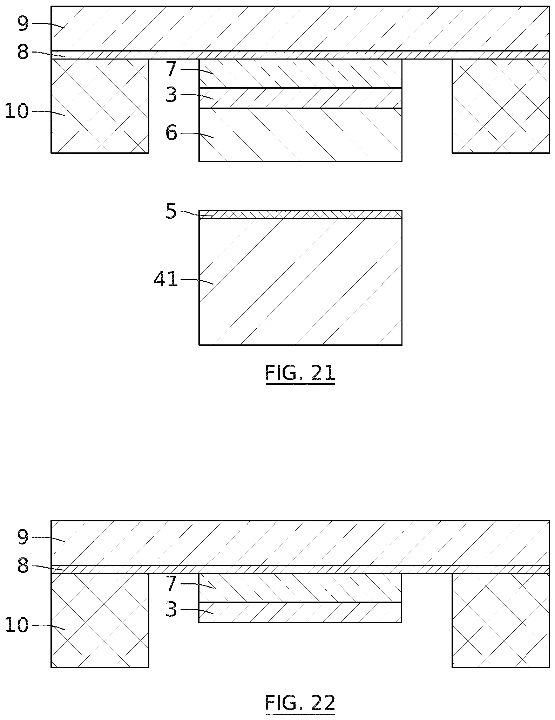

On donne ci-après des exemples de mise en œuvre du procédé de l'invention pour parvenir au transfert d'une couche mince (autrement appelée film fin) sur un substrat de destination. Un résultat que l'on peut obtenir à partir du procédé de l'invention est illustré de manière similaire aux figures 1 et 22. A ces figures, une couche mince 3 a été rapportée sur la face inférieure d'un substrat de destination 9. Ce report a été opéré par l'intermédiaire d'une couche d'interface 7 et d'une couche adhésive 8.

La couche mince 3 correspond à un dispositif micro-électronique, par exemple à base de matériaux semi-conducteurs, piézoélectriques ou encore électromagnétiques. La couche mince 3 peut comprendre des composants électriques actifs ou passifs, tels que des cellules photovoltaïques, des diodes, des MEMS ou plus simplement des circuits électriques composants tels que des transistors ou encore être une couche d'un matériau donnée uniquement. Avantageusement, la couche mince 3 présente une épaisseur inférieure à 500nm et de préférence à 200 nm.

Un intérêt non limitatif de la couche mince 3 est de préserver une certaine capacité de déformation en flexion de cette couche. En effet, il existe un besoin croissant pour des dispositifs micro-électroniques flexibles. Pour préserver la capacité de flexion tout en offrant un support pour la couche mince 3, le substrat de destination 9 de l'invention est avantageusement également flexible. Le substrat de destination 9 peut être formé à partir d'au moins une couche d'un matériau polymère. Il peut consister en ou comprendre une couche métallique. Ces exemples de matériaux ne sont évidemment pas limitatifs. De même, à titre indicatif, on indique que l'épaisseur du substrat de destination 9 peut être inférieure à 300 microns et/ou supérieure à 50 microns. Ce substrat flexible 9 peut être solidaire d'une structure rigide 10 qui permet de manipuler facilement l'ensemble substrat 9 associé à la couche mince 3 et de réaliser de nouvelles étapes technologiques sur la couche mince (dépôt, mise en contrainte, découpe, etc..).

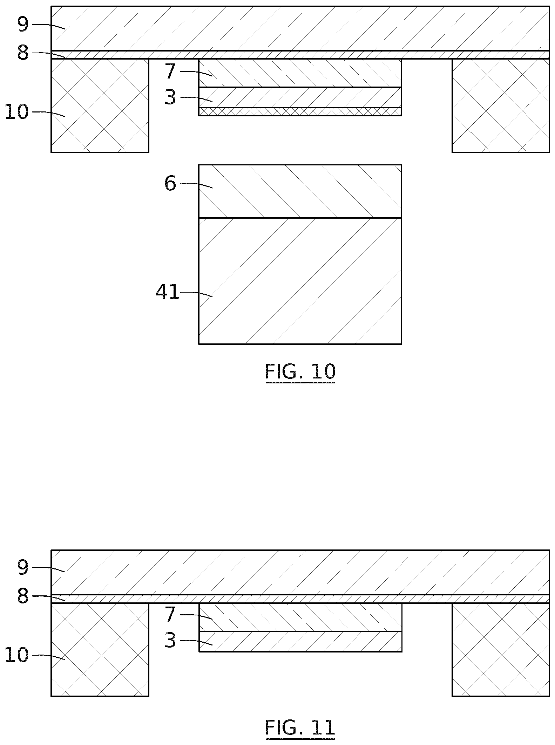

L'association du substrat de destination 9 et de la couche mince 3 permet donc, suivant un mode de réalisation avantageux, de disposer d'un ensemble dont la résistance mécanique est adaptée aux applications mais qui reste déformable en flexion. Un aspect lié à la résistance mécanique de l'ensemble est la combinaison des couches 7 et 8 représentées aux figures 11 et 22. En effet, selon l'invention, ces couches coopèrent de sorte à éviter la fissuration de la couche mince 3 pendant ou après les opérations de report sur le substrat de destination 9. De préférence, la couche d'interface 7 produit une surface plane au-dessus de la totalité d'une face de la couche mince 3. Avantageusement, la couche d'interface 7 coopère sur l'intégralité de sa face opposée à la couche mince 3 avec la couche adhésive 8.

La couche 8 a vocation à coller l'ensemble formé par la couche mince 3 et la couche d'interface 7 sur le substrat de destination 9. Elle assure aussi la fixation du substrat 9 sur la structure rigide 10. Il peut s'agir d'un polymère adhésif, par exemple un acrylate. Par exemple, l'épaisseur de la couche 8 est comprise entre 10 microns et 200 microns. De préférence, l'épaisseur de la couche 8 est supérieure à celle de la couche 7. La couche 8 peut être obtenue sur la base d'un support complexe associant le substrat de destination et la couche adhésive, comme par exemple commercialisé par la société Lintec Corporation sous la référence Adwill 675 ou par la société Furukawa sous la référence SP537T230. Néanmoins, on peut employer un substrat sous forme de simple feuille ou film de polymère et lui rapporter une couche adhésive lors de la mise en œuvre des étapes de report de la couche mince 3.

En ce qui concerne la couche d'interface 7, un matériau polymère peut également être utilisé. A titre d'exemple, il peut s'agir d'un polymère de référence BSI5150 commercialisé par Brewer ou encore de référence LC5200 commercialisé par 3M. L'épaisseur de cette couche peut par exemple être supérieure à 100 nm, avantageusement supérieure à 10 microns. Suivant une possibilité, l'épaisseur de la couche d'interface 7 est choisie supérieure à 1 micromètre, et est de préférence comprise entre 3 et 7 micromètres ; elle peut mesurer 5 micromètres. On peut éventuellement limiter l'épaisseur de cette couche à 100 microns. Avantageusement, la rugosité de type Ra de la face de la couche d'interface 7 destinée à l'assemblage avec la couche adhésive 8 est inférieure à 50 nm.

Les figures 1 à 6 présentent une succession d'étapes qui peuvent être mises en œuvre de sorte à parvenir à faire porter par un support temporaire 4 la couche mince 3 que l'on souhaite transférer sur le substrat de destination 9. On peut notamment partir d'un ensemble du type Silicium sur isolant (ou SOI) comprenant en empilement un substrat initial 1, une couche électriquement isolante enterrée 2 et la couche mince 3. La couche de base du substrat initial 1 est par exemple faite de silicium ou d'un autre matériau semi-conducteur. La couche électriquement isolante enterrée 2 est typiquement faite de dioxyde de silicium. Cette couche peut par exemple avoir une épaisseur de 200 nm. Sur cet ensemble bicouche se situe la couche mince 3 solidaire par sa deuxième face 32 de la face supérieure de la couche isolante enterrée 2.

La figure 2 illustre une étape pendant laquelle on ajoute à l'empilement précédent une couche de séparation 5 qui permettra ultérieurement de désolidariser la couche mince 3 du support temporaire 4. Un matériau polymère est utilisable pour la couche de séparation 5 tel que les produits de la société 3M portant les références NOVEC EGC 2702 et NOVEC EGC 1700 ou OPTOOL DSX de la société Daikin.

Ensuite, une couche d'assemblage 6 est rapportée à l'étape de la figure 3. Elle forme un adhésif temporaire permettant, comme illustré à la figure 4, la solidarisation avec le support temporaire 4. On peut utiliser pour cette couche les adhésifs de la société Brewer portant les références Bsi5150 ou Bsi305 ou celui de la société 3M portant la référence LC5200. Avantageusement, on s'arrange pour que l'énergie de collage entre la couche d'assemblage 6 et la couche de séparation 5 soit inférieure à l'énergie de collage existant entre la couche d'assemblage 6 et la face du support temporaire 41

Finalement, la couche mince 3 se retrouve portée par le support temporaire 4 et le substrat initial peut être retiré. Dans le cas d'une technique SOI, on enlève donc à ce stade la couche de base faite d'un matériau semi-conducteur et la couche enterrée 2. La figure 5 montre une étape intermédiaire de ce processus d'enlèvement dans laquelle seule subsiste la couche 2. On peut par exemple procéder par une série d'étapes d'amincissement par meulage et gravure chimique. On peut en outre opérer une implantation ionique dans la couche 2 de sorte à provoquer une rupture à ce niveau et éliminer le substrat initial. Finalement, on obtient le résultat présenté à la figure 6 au niveau de laquelle la couche mince 3 est exposée au-dessus du support temporaire 4, sa deuxième face 32 étant accessible. L'exemple ainsi donné est purement indicatif et tout autre mode de réalisation permettant d'obtenir le support de la couche mince 3 sur un support temporaire 4, avantageusement rigide, rentre dans le cas de la présente invention.

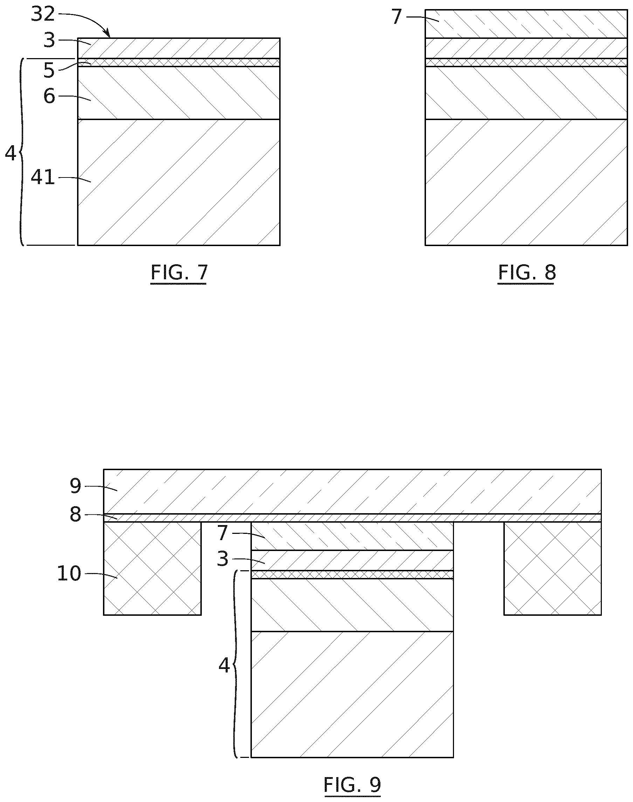

La figure 7 ne diffère pas substantiellement de la figure 6 mais l'empilement de couches y a subi une rotation de 180°.

Sur cette base, on forme, au-dessus de la deuxième face 32 de la couche mince 3, la couche d'interface 7 en référence à la figure 8. Cette formation peut comprendre le dépôt d'une forme liquide d'un polymère (en particulier polymère en solution ou précurseur liquide) sur la face 32 et son étalement, par exemple par enduction centrifuge de sorte à présenter une répartition aussi homogène que possible. La couche ainsi étalée est structurée. Cette structuration va dépendre de la forme liquide du polymère. Dans le cas d'un polymère en solution, on structure le matériau en le solidifiant en évacuant le solvant de la solution, notamment par une ou des étapes de recuit (tel que dans le cas du polymère Bsi5150). Dans le cas de précurseurs, on va structurer le matériau par réticulation, notamment en réticulant les précurseurs (recuit ou insolation pour le polymère LC5200 par exemple). Avantageusement, dans les 2 cas, la polymérisation ou d'une manière générale la structuration est complète et permet d'obtenir une face supérieure de l'ensemble présentant un état de surface améliorée relativement à celui de la deuxième face 32 de la couche mince 3.

Le transfert sur le substrat de destination 9 proprement dit est présenté à la figure 9. On peut ainsi laminer le substrat 9 sur la couche d'interface 7 par la face du substrat 9 qui comporte la couche adhésive 8. C'est cette dernière couche qui vient s'appliquer sur la face de la couche d'interface 7 opposée à la couche mince 3. Avantageusement dans le même temps, il est possible de positionner le substrat de destination 9 sur un cadre rigide 10 permettant le maintien périphérique du substrat 9 et rendant possible d'autres étapes technologiques. On tire ainsi profit de la couche adhésive 8 pour deux opérations simultanées.

À la figure 10, le support temporaire 4 peut être retiré par séparation entre la couche de séparation 5 et la couche d'assemblage 6. Cette dernière reste solidaire de la poignée 41 du support 4 alors que la couche de séparation 5 reste sur la couche mince 3. Éventuellement, la couche de séparation 5 peut être supprimée, par exemple par un traitement plasma ou chimique. Dès lors, la couche mince 3 est portée par le substrat de destination comme le montre la figure 11.

La suite d'étapes précédemment décrite peut être adaptée selon la nature des matériaux mis en œuvre, notamment pour la couche d'interface 7. Ainsi, sur le substrat aminci présenté en figure 7, on peut venir étaler par enduction centrifuge un film de couche d'interface 7 du matériau 3M LC-5200 par exemple de 10 µm. Le polymère est alors réticulé notamment sous UV (ultraviolets). On vient ensuite laminer un substrat de destination flexible complexe du type Furukawa SP537T230 à la fois sur cette couche 7 de polymère et sur un cadre rigide 10 par la couche adhésive du matériau Furukawa SP537T230. Le contact entre le substrat 9 et le polymère de la couche d'interface 7 d'une part et le contact entre le substrat 9 et le cadre 10 sont assurés par l'adhésif du substrat flexible. On démonte la poignée 41 rigide et on a ainsi récupéré la couche mince (par exemple faite par un film de silicium de 200 nm collé ; on n'observe alors aucun défaut sur le film fin de silicium).

Suivant un autre exemple, à partir du substrat aminci présenté en figure 7, on vient étaler par enduction centrifuge un film de polymère 3M LC-5200 par exemple de 100 µm pour former la couche d'interface 7. Le polymère est alors réticulé par exemple sous UV. On vient laminer un substrat 9 flexible (par exemple du type Furukawa SP537T230) à la fois sur cette couche de polymère et sur un cadre rigide 10. Le contact entre le substrat 9 flexible et le polymère de la couche 7 d'une part et le contact entre le substrat 9 flexible et le cadre 10 sont assurés par la couche adhésive 8 portée par le substrat 9. On retire la poignée du support temporaire 4 rigide et on a ainsi reporté la couche mince (par exemple un film de silicium de 200 nm collé sur l'adhésif 3M LC-5200 et dorénavant solidaire du substrat 9 flexible ; on n'observe alors aucun défaut sur le film fin de silicium).

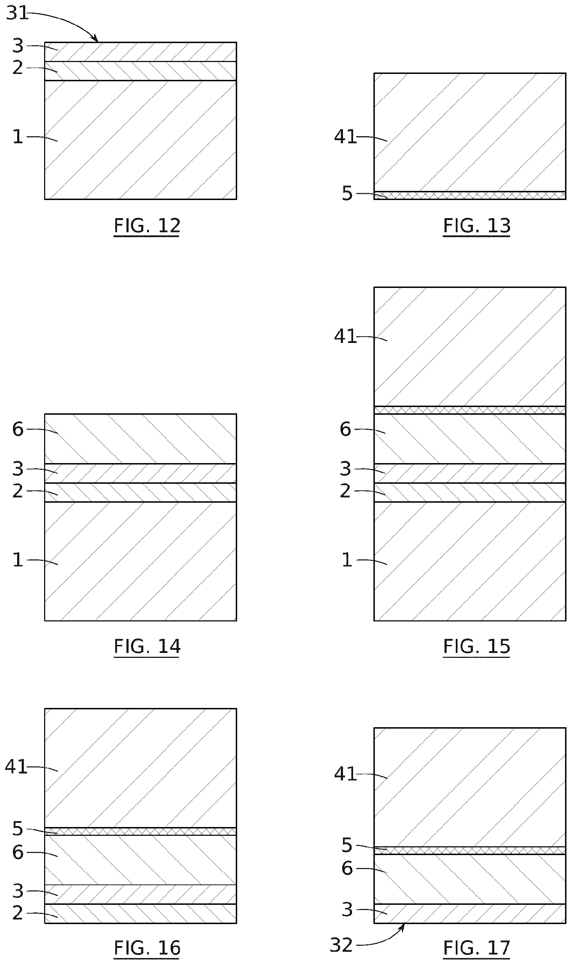

Les figures 12 à 22 présentent un autre mode de réalisation.

Comme précédemment, une série d'étapes optionnelles de l'invention permet de parvenir à la configuration dans laquelle la couche mince 3 présente une deuxième face 32 exposée au-dessus d'un support temporaire 4, comme le montre la figure 17. Pour y parvenir, on peut partir d'une situation initiale, présentée à la figure 12, identique à celle présentée à la figure 1. Cette fois, la couche de séparation 5 est disposée sur l'une des faces du support temporaire 4, comme illustré à la figure 13. En figure 14, la couche d'assemblage 6 est réalisée au-dessus de la couche mince 3 de l'empilement présenté à la figure 12. Finalement, les empilements des figures 13 et 14 sont assemblés par les faces exposées de la couche d'assemblage 6 et de la couche de séparation 5 de sorte à obtenir la configuration de la figure 15. Ainsi rapportée sur le support temporaire 4, la couche mince 3 peut être séparée du substrat initial 1 et notamment de la couche de base de ce substrat comme en figure 16 puis de la couche électriquement isolante enterrée 2 comme en figure 17. Les modalités décrites en référence aux figures 1 à 6 peuvent être appliqués mutatis mutandis au cas des figures 12 à 17.

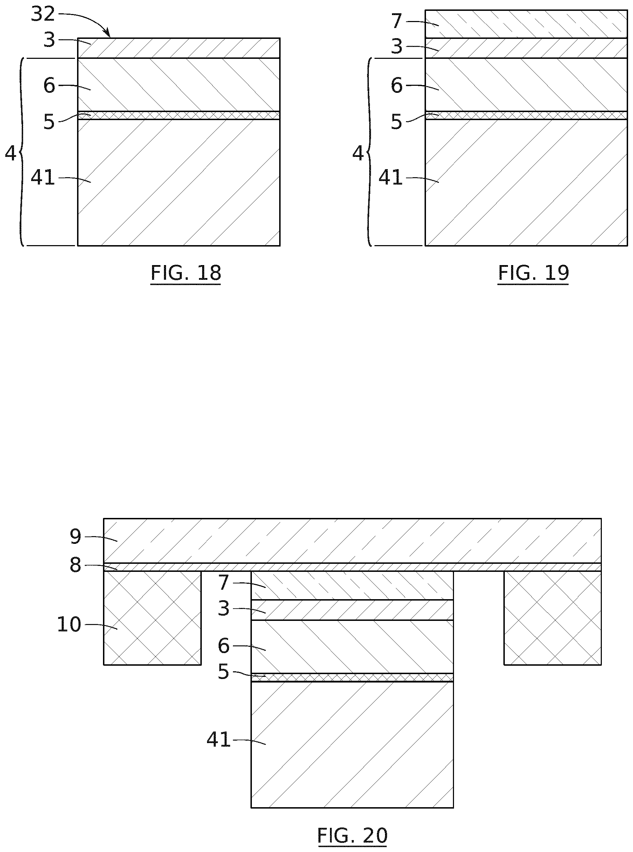

La figure 18 présente une configuration équivalente à celle de la figure 17 à ceci près qu'on a opéré un retournement de l'empilement. De façon similaire à ce qui était présenté dans les figures 8 et 9, on réalise en figures 19 et 20 d'abord la formation de la couche d'interface 7 puis le transfert de l'ensemble sur le substrat de destination 9 par l'intermédiaire de la couche adhésive 8.

Contrairement au cas de la figure 10, la séparation produite à la figure 21 préserve la couche de séparation 5 solidaire du support temporaire 4 alors que la couche d'interface 7 reste au contact de la couche mince 3. Cependant, la couche 7 peut être supprimée notamment par voie chimique de sorte à exposer la face de la couche mince 3. Hormis ces différences, les modalités décrites en référence aux figures 7 à 11 peuvent être mis en œuvre mutatis mutandis pour le mode de réalisation des figures 18 à 22.

Suivant un exemple particulier adapté à ce mode de réalisation, on étale par enduction centrifuge sur le substrat rigide aminci de la figure 18 une couche de polymère (par exemple du type Bsi305) notamment de 50 µm puis on la recuit à 220°C pour former la couche 7 en évacuant le solvant. On vient laminer un substrat 9 complexe et flexible (par exemple du type Furukawa SP537T230) à la fois sur cette couche 7 et sur un cadre 10. Le contact entre le substrat flexible et le second polymère d'une part et le contact entre le substrat 9 flexible et le cadre 10 sont assurés par la couche adhésive 8 présente sur le substrat 9 flexible. On retire la poignée 41 du support temporaire 4 rigide et on récupère la couche mince 3 ici par exemple un film de silicium de 200 nm emprisonné entre la couche 7 en matériau polymère et la couche d'assemblage temporaire (par exemple en matériau Bsi5150) et solidaire du substrat de destination 9 doté de la couche adhésive 8). Le nettoyage de la couche d'assemblage, qui est un l'adhésif temporaire (par exemple Bsi5150) en superficie du film fin ou couche mince 3 est réalisé, de préférence par voie chimique. On n'observe alors aucun défaut sur le film fin de silicium solidaire du substrat flexible par l'intermédiaire du polymère (notamment Bsi305) de la couche d'interface 7.

Sauf indication spécifique du contraire, des caractéristiques techniques décrites en détail pour un mode de réalisation donné peuvent être combinées à des caractéristiques techniques décrites dans le contexte d'autres modes de réalisation décrits à titre exemplaire et non limitatif, dont ceux expliqués en détail ci-dessus.

### REFERENCES

1. Substrat initial
2. Couche isolante enterrée
3. Couche mince
4. Support temporaire
5. Couche de séparation
6. Couche d'assemblage
7. Couche d'interface
8. Couche adhésive
9. Substrat de destination
10. Cadre de maintien
31. Première face
32. Deuxième face
41. Poignée

## Revendications

1. Procédé de transfert d'une couche mince (3) sur un substrat de destination (9) sur une face duquel une couche adhésive (8) est présente, **caractérisé en ce qu'**il comprend, à partir d'un support temporaire (4) à une face duquel une première face (31) de la couche mince (3) est solidarisée :
- une formation d'une couche d'interface (7) en matériau polymère sur une deuxième face (32) de la couche mince (3), opposée à la première face (31), la formation de la couche d'interface (7) comprenant un étalement d'une forme liquide du matériau polymère sur la deuxième face (32) de la couche mince (3) puis une structuration du matériau polymère en phase solide; puis
- un assemblage par collage de la couche d'interface (7) et de la couche adhésive (8) ; puis
- une séparation de la couche mince (3) relativement au support temporaire (4).

2. Procédé selon la revendication précédente, dans lequel on utilise un support temporaire (4) comprenant une couche de séparation (5) et une poignée (41), la couche de séparation (5) étant disposée entre la couche mince (3) et la poignée (41) du support temporaire (4) lorsqu'ils sont solidarisés, et dans lequel la séparation est réalisée par une décohésion de la couche de séparation (5) relativement à la couche mince (3) ou à la poignée (41).

3. Procédé selon la revendication précédente, dans lequel la couche de séparation (5) est disposée au contact de la première face (31) de la couche mince (3) lorsque le support temporaire (4) et la couche mince (3) sont solidarisés et dans lequel on utilise un support temporaire (4) comprenant une couche d'assemblage (6) disposée entre la couche de séparation (5) et la poignée (41), et dans lequel la décohésion a lieu à l'interface entre la couche de séparation (5) et la couche d'assemblage (6).

4. Procédé selon la revendication 2 dans lequel la couche de séparation (5) est disposée au contact de la poignée (41) lorsque le support temporaire (4) et la couche mince (3) sont solidarisés et dans lequel on utilise un support temporaire (4) comprenant une couche d'assemblage (6) disposée entre la couche de séparation (5) et la couche mince (3), et dans lequel la décohésion a lieu à l'interface entre la couche de séparation (5) et la couche d'assemblage (6).

5. Procédé selon l'une des revendications précédentes, comprenant une fixation du substrat de destination (9) sur un cadre de maintien (10) par collage d'une surface du cadre de maintien (10) sur la couche adhésive (8).

6. Procédé selon la revendication précédente, dans lequel la fixation est opérée simultanément à l'assemblage.

7. Procédé selon l'une des revendications précédentes, comprenant un transfert préliminaire de la couche mince (3) depuis un substrat initial (1) vers le support temporaire (4).

8. Procédé selon la revendication précédente, dans lequel on utilise un substrat initial (1) comprenant une couche de base et une couche d'isolant électrique enterrée (2), la deuxième face (32) de la couche mince (3) étant disposée au contact de la couche d'isolant électrique enterrée (2).

9. Procédé selon la revendication précédente, comprenant une désolidarisation de la couche mince (3) relativement au substrat initial (1) par amincissement de la couche de base et de la couche d'isolant électrique enterrée (2) ou par rupture de la couche d'isolant électrique.

10. Procédé selon l'une des revendications précédentes, dans lequel on utilise une couche adhésive (8) en matériau polymère, de préférence avec une épaisseur supérieure ou égale à 10 µm et/ou inférieure ou égale à 200 µm.

11. Procédé selon l'une des revendications précédentes, dans lequel l'épaisseur de la couche d'interface (7) est choisie supérieure à 100 nm, et de préférence supérieure ou égale à 10 µm.

12. Procédé selon l'une des revendications 1 à 10, dans lequel l'épaisseur de la couche d'interface (7) est choisie supérieure à 1 micromètre, et de préférence comprise entre 3 et 7 micromètres.

13. Procédé selon l'une des revendications précédentes, dans lequel l'épaisseur de la couche d'interface (7) est choisie inférieure ou égale 200 µm, et de préférence inférieure ou égale à 100 µm et/ou dans lequel la couche mince (3) est choisie avec une épaisseur inférieure à 500 nm et de préférence inférieure ou égale à 200 nm.

14. Procédé selon l'une des revendications précédentes, dans lequel la couche mince (3) est choisie à base d'au moins un parmi : un matériau semi-conducteur, un matériau magnétique, un matériau piézoélectrique.

15. Procédé selon l'une des revendications précédentes, dans lequel le substrat de destination (9) est choisi sous forme d'une feuille de matériau polymère.

## Patentansprüche

1. Verfahren zum Übertragen einer Dünnschicht (3) auf ein Zielsubstrat (9), auf einer Seite dessen eine Klebeschicht (8) vorhanden ist, **dadurch gekennzeichnet, dass** es, ausgehend von einem temporären Träger (4), auf einer Seite dessen eine erste Seite (31) der Dünnschicht (3) befestigt ist, umfasst:
- ein Bilden einer Grenzflächenschicht (7) aus Polymermaterial auf einer der ersten Seite (31) gegenüberliegenden zweiten Seite (32) der Dünnschicht (3), wobei das Bilden der Grenzflächenschicht (7) ein Ausbreiten einer flüssigen Form des Polymermaterials auf der zweiten Seite (32) der Dünnschicht (3), und anschließend ein Strukturieren des Polymermaterials in fester Phase umfasst; und anschließend
- ein Zusammenfügen durch Verkleben der Grenzflächenschicht (7) und der Klebeschicht (8); und anschließend
- ein Trennen der Dünnschicht (3) in Bezug auf den temporären Träger (4).

2. Verfahren nach dem vorstehenden Anspruch, wobei ein temporärer Träger (4) verwendet wird, der eine Trennschicht (5) und einen Griff (41) umfasst, wobei die Trennschicht (5) zwischen der Dünnschicht (3) und dem Griff (41) des temporären Trägers (4) angeordnet ist, wenn diese fest miteinander verbunden sind, und wobei das Trennen durch eine Dekohäsion der Trennschicht (5) in Bezug auf die Dünnschicht (3) oder den Griff (41) ausgeführt wird.

3. Verfahren nach dem vorstehenden Anspruch, wobei die Trennschicht (5) in Kontakt mit der ersten Seite (31) der Dünnschicht (3) angeordnet ist, wenn der temporäre Träger (4) und die Dünnschicht (3) fest miteinander verbunden sind, und wobei ein temporärer Träger (4) verwendet wird, der eine Fügeschicht (6) umfasst, die zwischen der Trennschicht (5) und dem Griff (41) angeordnet ist, und wobei die Dekohäsion an der Grenzfläche zwischen der Trennschicht (5) und der Fügeschicht (6) stattfindet.

4. Verfahren nach Anspruch 2, wobei die Trennschicht (5) in Kontakt mit dem Griff (41) angeordnet ist, wenn der temporäre Träger (4) und die Dünnschicht (3) fest miteinander verbunden sind, und wobei ein temporärer Träger (4) verwendet wird, der eine Fügeschicht (6) umfasst, die zwischen der Trennschicht (5) und der Dünnschicht (3) angeordnet ist, und wobei die Dekohäsion an der Grenzfläche zwischen der Trennschicht (5) und der Fügeschicht (6) stattfindet.

5. Verfahren nach einem der vorstehenden Ansprüche, das ein Fixieren des Zielsubstrats (9) an einem Halterahmen (10) durch Verkleben einer Fläche des Halterahmens (10) an der Klebeschicht (8) umfasst.

6. Verfahren nach dem vorstehenden Anspruch, wobei das Fixieren gleichzeitig mit dem Zusammenfügen vorgenommen wird.

7. Verfahren nach einem der vorstehenden Ansprüche, das ein vorbereitendes Übertragen der Dünnschicht (3) von einem Anfangssubstrat (1) auf das temporäre Substrat (4) umfasst.

8. Verfahren nach dem vorstehenden Anspruch, wobei ein Anfangssubstrat (1) verwendet wird, das eine Basisschicht und eine vergrabene elektrische Isolierschicht (2) umfasst, wobei die zweite Seite (32) der Dünnschicht (3) in Kontakt mit der vergrabenen elektrischen Isolierschicht (2) angeordnet ist.

9. Verfahren nach dem vorstehenden Anspruch, das ein Ablösen der Dünnschicht (3) in Bezug auf das Anfangssubstrat (1) durch Verdünnen der Basisschicht und der vergrabenen elektrischen Isolierschicht (2) oder durch Zerreißen der elektrischen Isolierschicht umfasst.

10. Verfahren nach einem der vorstehenden Ansprüche, wobei eine Klebeschicht (8) aus Polymermaterial, vorzugsweise mit einer Dicke von größer oder gleich 10 µm und/oder kleiner oder gleich 200 µm verwendet wird.

11. Verfahren nach einem der vorstehenden Ansprüche, wobei die Dicke der Grenzflächenschicht (7) größer als 100 nm, und vorzugsweise größer oder gleich 10 µm gewählt wird.

12. Verfahren nach einem der Ansprüche 1 bis 10, wobei die Dicke der Grenzflächenschicht (7) größer als 1 Mikrometer gewählt wird und vorzugsweise im Bereich zwischen 3 und 7 Mikrometer liegt.

13. Verfahren nach einem der vorstehenden Ansprüche, wobei die Dicke der Grenzflächenschicht (7) kleiner oder gleich 200 µm, und vorzugsweise kleiner oder gleich 100 µm gewählt wird, und/oder wobei die Dünnschicht (3) mit einer Dicke von kleiner als 500 nm, und vorzugweise kleiner oder gleich 200 nm gewählt wird.

14. Verfahren nach einem der vorstehenden Ansprüche, wobei die Dünnschicht (3) auf Basis von mindestens einem gewählt wird aus: einem Halbleitermaterial, einem magnetischen Material, einem piezoelektrischen Material.

15. Verfahren nach einem der vorstehenden Ansprüche, wobei das Zielsubstrat (9) in Form einer Folie aus Polymermaterial gewählt wird.

## Claims

1. Method for transferring a thin layer (3) on a destination substrate (9) on a face of which an adhesive layer (8) is present, **characterised in that** it comprises, from a temporary support (4) to a face of which a first face (31) of the thin layer (3) is secured:
- a formation of an interface layer (7) made of polymer material on a second face (32) of the thin layer (3), opposite the first face (31), the formation of the interface layer (7) comprising a spreading of a liquid form of the polymer material on the second face (32) of the thin layer (3) then a structuring of the polymer material in the solid phase; then
- an assembly by gluing the interface layer (7) and the adhesive layer (8) ; then
- a separation of the thin layer (3) relative to the temporary support (4).

2. Method according to the preceding claim, wherein a temporary support (4) is used comprising a separation layer (5) and a handle (41), the separation layer (5) being arranged between the thin layer (3) and the handle (41) of the temporary support (4) when they are secured, and wherein the separation is made by a decohesion of the separation layer (5) relative to the thin layer (3) or to the handle (41).

3. Method according to the preceding claim, wherein the separation layer (5) is arranged in contact with the first face (31) of the thin layer (3) when the temporary support (4) and the thin layer (3) are secured and wherein a temporary support (4) is used comprising an assembly layer (6) arranged between the separation layer (5) and the handle (41), and wherein the decohesion occurs at the interface between the separation layer (5) and the assembly layer (6).

4. Method according to claim 2, wherein the separation layer (5) is arranged in contact with the handle (41) when the temporary support (4) and the thin layer (3) are secured and wherein a temporary support (4) is used comprising an assembly layer (6) arranged between the separation layer (5) and the thin layer (3), and wherein the decohesion occurs at the interface between the separation layer (5) and the assembly layer (6).

5. Method according to one of the preceding claims, comprising a fixing of the destination substrate (9) on a holding frame (10) by gluing a surface of the holding frame (10) on the adhesive layer (8).

6. Method according to the preceding claim, wherein the fixing is performed simultaneously to the assembly.

7. Method according to one of the preceding claims, comprising a preliminary transfer of the thin layer (3) from an initial substrate (1) to the temporary support (4).

8. Method according to the preceding claim, wherein an initial substrate (1) is used comprising a base layer and a buried electrical insulating layer (2), the second face (32) of the thin layer (3) being arranged in contact with the buried electrical insulating layer (2).

9. Method according to the preceding claim, comprising a disconnection of the thin layer (3) relative to the initial substrate (1) by thinning the base layer and the buried electrical insulating layer (2) or by breaking the electrical insulating layer.

10. Method according to one of the preceding claims, wherein an adhesive layer (8) made of polymer material is used, preferably with a thickness greater than or equal to 10µm and/or less than or equal to 200µm.

11. Method according to one of the preceding claims, wherein the thickness of the interface layer (7) is selected greater than 100nm, and preferably greater than or equal to 10µm.

12. Method according to one of claims 1 to 10, wherein the thickness of the interface layer (7) is selected greater than 1 micrometre, and preferably comprised between 3 and 7 micrometres.

13. Method according to one of the preceding claims, wherein the thickness of the interface layer (7) is selected less than or equal to 200µm, and preferably less than or equal to 100µm and/or wherein the thin layer (3) is selected with a thickness less than 500nm and preferably less than or equal to 200nm.

14. Method according to one of the preceding claims, wherein the thin layer (3) is selected based on at least one from among: a semiconductive material, a magnetic material, a piezoelectric material.

15. Method according to one of the preceding claims, wherein the destination substrate (9) is selected in the form of a sheet of polymer material.
